Europäisches Patentamt

European Patent Office

Office européen des brevets

(19)

(11) Publication number: **0 051 134**
**B1**

(12) **EUROPEAN PATENT SPECIFICATION**

(45) Date of publication of patent specification: **08.01.86**

(51) Int. Cl.⁴: **H 01 L 29/78, H 01 L 29/10**

(21) Application number: **81107091.1**

(22) Date of filing: **09.09.81**

(54) **Field effect transistor circuit arrangements.**

(30) Priority: **03.11.80 US 203037**

(43) Date of publication of application:
**12.05.82 Bulletin 82/19**

(45) Publication of the grant of the patent:
**08.01.86 Bulletin 86/02**

(84) Designated Contracting States:
**DE FR GB IT**

(56) References cited:
**US-A-3 946 419**
**US-A-4 081 817**
**US-A-4 153 906**

**IEEE TRANSACTIONS ON ELECTRON
DEVICES; VOL: ED-26, no. 11, November 1979,
New York, S. SHUR et al., "Ballistic transport in
semiconductor at low temperatures for low-
power high-speed logic"
IEEE ELECTRON DEVICE LETTERS, vol. EDL-1,
no. 10, October 1980, New York, R. BARKER et
al. "On the nature of ballistic transport in
short-channel semiconductor devices"**

(73) Proprietor: **International Business Machines
Corporation
Old Orchard Road
Armonk, N.Y. 10504 (US)**

(72) Inventor: **Fang, Frank Fu
1691 Cardinal Court
Yorktown Heights New York 10598 (US)**
Inventor: **Sai-Halasz, George Anthony
26 Timber Ridge
Mt. Kisco New York 10549 (US)**

(74) Representative: **Hobbs, Francis John
IMB United Kingdom Patent Operations
Hursley Park
Winchester, Hants, SO21 2JN (GB)**

Courier Press, Leamington Spa, England.

## Description

This invention relates to field effect transistor circuit arrangements.

Much progress has been made in providing better and better FET devices. For some time there has been considerable effort in reducing the channel length to provide higher performance and higher density Large Scale Integration (LSI) circuit chips. However, there are fundamental aspects of the device operation which prevent the reduction process from going on indefinitely. One of the limitations is that the source and drain depletion regions overlap when the channel length is reduced to twice the width of the depletion area, and this causes punchthrough between the source and drain regions. Generally, the depletion width in moderate doping is in the order of hundreds of nanometers and modern electron beam lithography is capable of producing devices of channel length less than 100 nm. Devices of this configuration will cease to operate in the conventional manner at such relative dimensions.

US—A—4,081,817 seeks to solve the problem of making a group of FETs all having substantially the same gate threshold voltage despite variations in the channel lengths of the FET's in the group. The proposed solution is to so dope the substrate and the source and drain regions that the depletion layer extending from the source contacts the depletion layer extending from the drain.

US—A—3,946,419 discloses the use of a relatively highly doped region buried under the channel of an FET in order to increase the punch through voltage which produces an undesirable meeting of the depletion regions extending from the source and drain regions.

In IEEE Transactions on Electron Devices, Vol ED-26, No. 11, November 1979, pages 1677—1683 "Ballistic Transport . . ." by M. S. Shur et al, the current voltage characteristics of a "ballistic" FET are analysed. It is shown that at low temperatures when the mean-free path of electrons in semiconductors exceeds the gate length the electrons travel like an electron beam without undergoing any lattice-scattering and as a result reach high values of drift velocity at very low voltages leading to short propagation delay and low-power consumption.

The invention seeks to solve the problem of providing and operating a field effect transistor with a very short channel.

According to the invention, the operation of field effect transistors is based on the control and modulation of the punchthrough phenomenon as well as the space charge limited conduction of channel current.

According to the invention, there is provided a field effect transistor circuit arrangement comprising a field effect transistor having a channel extending between a source and a drain and through which a modulated current is caused to flow by application of a signal to a gate electrode adjacent to, but insulated from the channel, characterised by the field effect transistor being so formed that current flow between the source and drain is restricted to the channel, by the channel being sufficiently short and so doped that a depletion zone extending through the channel from the source overlaps a depletion zone extending through the channel from the drain so providing in the region of the channel where the depletion zones overlap a potential barrier inhibiting current flow from the source to the drain, and by the application of a potential bias to the gate electrode to reduce said potential barrier in said region of the channel so that current can flow through the channel when the drain is appropriately biased with respect to the source.

How the invention can be carried out will now be described by way of example, with reference to the accompanying drawings, in which:—

Fig. 1 represents a cross-section of a Field Effect Transistor (FET) according to the invention;

Fig. 2A, 2B and 3 are graphical representations of electron energy distributions in the structure of an FET according to the invention;

Fig. 4 is a graphical representation of the current-potential characteristic of the FET; and

Fig. 5 is a cross-section of an alternative embodiment of an FET according to the invention.

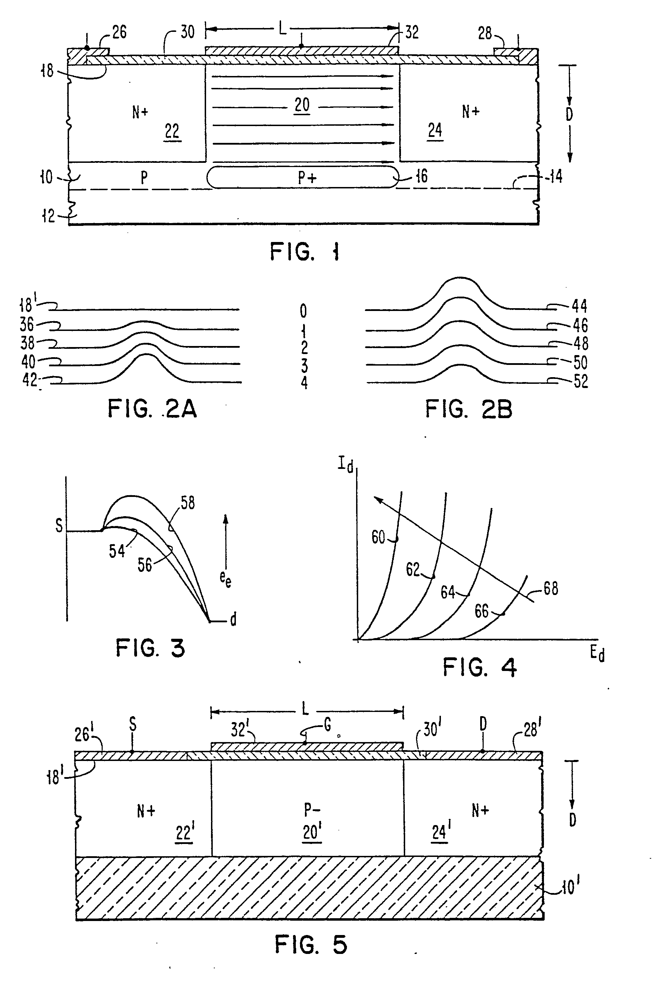

An example of a field effect transistor (FET) structure according to the invention is given in Fig. 1 in schematic representation. A substrate 10, for example, a suitably doped p-type silicon wafer, forms the body of the FET. Following conventional methods, p and p+ silicon are deposited to form a p region in which a p+ layer is buried as the process progresses. The buried layer 16 may be formed, for example, by ion implantation from the upper surface 18 of a silicon wafer with appropriate energy and dosage of boron. The buried layer 16 is arranged to underlie the channel 20 of the FET, which channel is defined by the distance between the depth diffused or implanted n+ source-22 and drain-24 regions, the latter of which have electrodes 26 and 28 respectively attached. The depth of the buried layer is not overly critical, a depth of a few thousand angstroms is sufficient. As will be discussed more fully hereinafter, the buried layer 16 is to form a high barrier between the source and drain and restrict the current flow to the channel region 20. The region below the gate and above the p+ implant remains much as in the original substrate from which it was formed. An insulated layer 30, such as $SiO_2$, is thermally grown on the upper surface 18 above which a gate electrode 32 is arranged.

The channel region 20 of length L between the source and drain is appropriately doped p-type such that the n+ doped source and drain depletion regions overlap, but the overlapped region is such that in the absence of the gate field it has a potential barrier for electrons high enough to prevent the injection of electrons for channel conduction. The actual barrier height potential in the absence of the applied field is determined by the channel doping and channel length L. When a positive voltage is applied to the gate 32, the gate field will cause the potential barrier in the channel 20 to be reduced below kT/q, and current will flow between the source and the drain throughout the depth of the channel. The potential profiles, with and without the applied positive gate voltage, are shown schematically in Figs. 2A and 2B respectively. The O profile 18' is at the interface between the channel and the gate oxide. The numbers 0—4 depict relative depth into the channel measured from the interface. In addition to the gate field, the source-drain voltage introduces a longitudinal field which also modulates and distorts the barrier such as shown in Fig. 3. The parameters 54, 56 and 58 associated with each potential profile, depict the distances from the oxide-Si interface 18 into the channel 20, in that order. Here a positive gate voltage is applied.

It is seen from these figures that two limiting factors enter into the current flow under the conditions described. Namely, the emission limited current and space charge limited current in the channel 20 and near the interface 18 respectively. The emission limited current is a strong function of the barrier height, $\Phi_B$, $\Phi_B$ {~exp $(-\Phi_B/kT)$}. As $\Phi_B/kT$ decreases due to the applied gate potential, space charge in the channel will limit the current. The space charge limited current is a strong function of the drain voltage $V_d$ and channel length $L \sim V_d^2 L^{-3}$ in case of scattering limited, and $\sim V_D^{3/2} L^{-2}$ in case of ballistic transport for an extremely short channel where channel length is smaller than the mean free path. Thus a new class of device is realized, one whose transfer I—E characteristics are shown schematically in Fig. 4 with considerably larger current gain than the conventional inversion layer FET, especially for a small channel length L. The depth of the channel is controlled by a buried p+ region 16 shown in Fig. 1 beneath the desired channel depth that it is desired to modulate. The p+ region 16 will be a high barrier for electrons between the source and drain regions, thus stopping an undesirable parasitic current flow.

An alternative structure in accordance with the invention is shown in Fig. 5, again in schematic representation. Here an insulating substrate 10' is provided preferably of sapphire. Silicon regions 20', 22' and 24' are deposited on the sapphire substrate in well known manner used in fabricating Silicon-On-Sapphire (SOS) transistors. Several arrangements are possible. The essential structure has a channel region 20' of one conductivity type, p— as shown for example, and source and drain regions of the opposite conductivity, n+ as shown in the example. The channel region has a length L less than twice the depletion width of the source and drain regions 22' and 24'. The insulating substrate 10' performs the function of the buried layer 16 in the previously described embodiment. Current is thus restricted to the channel region 20. In both embodiments, the channel width may be shorter than the mean free path of the conduction carriers whereby the FET operates in a ballistic region wherein the electron velocity exceeds the saturation velocity resulting from energy loss to the crystal lattice.

## Claims

1. A field effect transistor circuit arrangement comprising a field effect transistor having a channel (20) extending between a source (22) and a drain (24) and through which a modulated current is caused to flow by application of a signal to a gate electrode (32) adjacent to, but insulated from the channel, characterised by the field effect transistor being so formed that current flow between the source and drain is restricted to the channel, by the channel being sufficiently short and so doped that a depletion zone extending through the channel from the source overlaps a depletion zone extending through the channel from the drain so providing in the region of the channel where the depletion zones overlap a potential barrier inhibiting current flow from the source to the drain, and by the application of a potential bias to the gate electrode to reduce said potential barrier in said region of the channel so that current can flow through the channel when the drain is appropriately biased with respect to the source.

2. A circuit arrangement as claimed in claim 1, in which the field effect transistor has a buried region (16) of enhanced-conductivity material of said one conductivity type arranged to underlie the channel to prevent parasitic current flow between the source and the drain.

3. A circuit arrangement as claimed in claim 2, in which the substrate is of p type material, the source and drain regions are of n+ type material, and the buried region is of p+ type material.

4. A circuit arrangement as claimed in claim 1, in which the field effect transistor comprises a substrate (10', Fig. 5) of sapphire, a channel of semiconductor material of one conductivity type deposited on the substrate, and source and drain regions of semiconductor material of conductivity type opposite to that of said one type deposited on the substrate and spaced apart by the channel.

5. A circuit arrangement as claimed in any preceding claim, in which the channel of the field effect transistor has a length no greater than the mean free path of the conduction carriers whereby the transistor is operable in a ballistic region wherein the electron velocity exceeds the saturation velocity resulting from energy loss to the lattice.

## Revendications

1. Agencement de circuit à transistor à effet de champ, comprenant un transistor à effet de champ comportant un canal (20) s'étendant entre une source (22) et un drain (24) et dans lequel on peut faire passer un courant modulé per application d'un signal à une électrode de grille (32) adjacente au canal mais isolée de celui-ci, caractérisé en ce que le transistor à effet de champ est formé de telle sorte que le passage du courant entre la source et le drain est limité au canal, en ce que le canal est suffisamment court et dopé pour qu'ne zone d'appauvrissement s'étendant dans le canal à partir de la source chevauche une zone d'appauvrissement s'étendant dans le canal à partir du drain de façon à créer dans la région du canal où les zones d'appauvrissement se chevauchent une barrière de potentiel empêchant le passage du courant de la source vers la drain, et en ce qu'un potentiel de polarisation est appliqué à l'électrode de grille pour réduire la barrière de potentiel dans ladite région du canal de façon que le courant puisse passer dans le canal quand le drain est polarisé de façon appropré par rapport à la source.

2. Agencement de circuit comme revendiqué dans la revendication 1, dans lequel le transistor à effect de champ comporte une région enfouie (16) formée d'une matière à conductivité renforcée possédant le premier type d conductivité cité, et agencée pour être placée en dessous du canal afin d'empêcher un passage de courant parasite entre la source et le drain.

3. Agencement de circuit comme revendiqué dans la revendication 2, dans lequel le substrat est une matière de type p, les régions de source et de drain sont formées d'une matière de type n+ et la région enfouie est formée d'un matière de type p+.

4. Agencement de circuit comme revendiqué dans la revendication 1, dans lequel le transistor à effet de champ comprend un substrat (10', Fig. 5) en saphir, un canal en matière semiconductrice d'un certain type de conductivité qui est déposée sur le substrat, et des régions de source et de drain en matière semiconductrice d'un type de conductivité opposé au type déposé sur le substrat, et espacées l'une de l'autre par le canal.

5. Agencement de circuit comme revendiqué dans l'une quelconque des revendications précédentes, dans lequel le canal du transistor à effet de champ a une longueur non supérieure au trajet libre moyen des porteurs de conduction, de façon que le transistor puisse fonctionner dans une région balistique où la vitesse des électrons dépasse la vitesse de saturation résultant d'une perte d'énergie dans le réseau cristallin.

**Patentansprüche**

1. Feldeffekttransistor-Schaltungsanordnung mit einem Feldeffekttransistor, welcher einen sich zwischen einer Source (22) und einer Drain (24) erstreckenden Kanal (20) aufweist, in welchem durch Aufgabe eines Signals auf eine zum Kanal benachbarte aber von diesem isolierte Gate-Elektrode (32) ein modulierter Strom erzeugt wird, dadurch gekennzeichnet, daß der Feldeffekttransistor so ausgebildet ist, daß zwischen der Source und der Drain fließender Strom auf den Kanal beschränkt ist, daß der Kanal ausreichend kurz und so dotiert ist, daß eine sich aus der Source durch den Kanal erstreckende Verarmungszone eine sich aus der Drain durch den Kanal erstreckende Verarmungszone überlappt, womit sich in dem Bereich des Kanals, wo die Verarmungszonnen einander überlappen, eine Potentialbarrier ergibt, welche einen Stromfluß aus der Source in die Drain sperrt, und daß ein Vorspannungspotential an die Gate-Elektrode zur Verringerung der Potentialbarriere in diesem Bereich des Kanals angelegt wird, so daß Strom durch den Kanal fließen kann, wenn die Drain gegenüber der Source geeignet vorgespannt ist.

2. Schaltungsanordnung nach Anspruch 1, bei welcher der Feldeffekttransistor einen begrabenen Bereich (16) aus einem anreicherungsleitfähigen Material des einen Leitungstyps unter dem Kanal liegend angeordnet zur Verhinderung eines parasitären Stromflusses zwischen Source und Drain aufweist.

3. Schaltungsanordnung nach Anspruch 2, bei welcher das Substrat aus p-Material ist, die Source- und Drain-Bereich aus $n^+$-Material sind und der begrabene Bereich aus $p^+$-Material ist.

4. Schaltungsanordnung nach Anspruch 1, bei welcher der Feldeffekttransistor ein Substrat (10', Fig. 5) aus Saphir, einen Kanal aus auf dem Substrat abgeschiedenen Halbleitermaterial eines Leitungstyps, und Source- und Drain-Bereiche aus Halbleitermaterial mit zu dem des auf dem Substrat abgeschiedenen des einen Typs entgegengesetztem Leitungstyp getrennt durch den Kanal aufweist.

5. Schaltungsanordnung nach irgendeinem vorstehenden Anspruch, bei welcher der Kanal des Feldeffekttransistors eine Länge nicht größer als die mittlere freie Weglänge der Leitungsträger aufweist, wodurch der Transistor in einem ballistischen Bereich betreibbar ist, in welchem die Elektronengeschwindigkeit die aus Energieverlusten im Gitter resultierende Sättigungsgeschwindigkeit überschreitet.

FIG. 1

FIG. 2A

FIG. 2B

FIG. 3

FIG. 4

FIG. 5